# EUROPEAN PATENT APPLICATION

(11) **EP 2 535 433 A2**
(43) Date of publication of application: **19.12.2012**
(21) Application number: 10845319.2
(22) Date of filing: 28.10.2010
(51) Int. Cl.: C22C 9/00, C22F 1/08

(54) **COPPER ALLOY HAVING HIGH STRENGTH AND HIGH CONDUCTIVITY, AND PREPARATION METHOD THEREOF**

(30) Priority: 08.02.2010 KR 20100011356
(71) Applicant: Poongsan Corporation, Seoul 100-130 (KR)
(72) Inventor: KIM, Dae Hyun, Ulsan-si 680-812 (KR); LEE, Dong Woo, Daejeon 302-752 (KR); KIM, In Dal, Anyang-si Gyeonggi-do 431-080 (KR); CHOI, Sang Young, Seoul 138-160 (KR); LEE, Ji Hoon, Ulju-gun Ulsan-si 689-805 (KR); JEON, Bo Min, Ulsan-si 680-794 (KR)
(74) Representative: Norman, Pia Christiane
(86) International application number: PCT/KR2010/007462
(87) International publication number: WO 2011/096632

(57) **Abstract**

The present invention relates to a copper alloy which has both tensile strength and electrical conductivity superior to those of known products by suitably mixing a copper alloy composition, and is thus appropriate for electric and electronic parts, such as a terminal, a connector, a switch, a relay and the like. The copper alloy having high strength and high conductivity has the composition of comprising 0.05wt% of Fe, 0.025 - 0.15wt% of P, 0.01 ∼ 0.25wt% of Cr, 0.01 - 0.15wt of Si, 0.01 ∼ 0.25wt% of Mg, and the balance of Cu and inevitable impurities. In addition, the present invention relates to a preparation method of the copper alloy having high strength and high conductivity comprises the following steps: obtaining molten metal of the composition; casting the molten metal to obtain ingot; hot rolling the ingot at 850 - 1,000°C; cold rolling the hot rolled product after cooling the same; annealing the cold rolled product at 400 - 600°C for 1 - 10 hours; intermediate rolling the annealed product with a reduction ratio of 30 ∼ 70%; heat treating the intermediate rolled product at 500 - 800 °C for 30 ∼ 600 seconds; and finishing rolling the heat treated product with a reduction ratio of 20 ∼ 40%.

## Description

### [TECHNICAL FIELD]

The present invention relates to a copper alloy suitable for semiconductor lead frame material, LED lead frame material, and so on having high conductibility and high workability while increasing or maintaining tensile strength, and a method for preparing the same.

### [BACKGROUND ART]

In general, a Cu-Fe-P alloy is used as a copper alloy for a lead frame. For an example, a copper alloy (C19210) containing 0.05-0.15wt% Fe, and 0.025-0.04wt% P, and a copper alloy (CDA194) containing 2.1∼2.6wt% Fe, 0.015∼0.15wt% P, and 0.05∼0.20wt% Zn are generally used as international standard copper alloys owing to excellent strength and conductibility.

However, as a trend of fabrication of devices heads for high density integration, or fabrication of a smaller device, besides electric and heat conductivity, a copper alloy for high conductivity having an excellent surface state, such as high elongation and high platability required for workability is in demand, more strongly.

Though an advantage of the Cu-Fe-P alloy is the high conductivity, contents of Fe and P are increased, or third elements, such as Sn, Mg, Ca, and so on are also added for high strength. However, though the strength increases if the contents of the elements increase, the conductivity becomes poorer, inevitably. Therefore, there is a limitation in realizing a copper alloy only by controlling composition of the copper alloy, which has a good balance of high conductivity and high strength or is made above properties coexistent that is required according to the trend of fabricating a semiconductor device to have a large capacity, to be smaller, and to have high performance.

Japanese Laid Open Patent No. 2001-244400 discloses, in Example 1, a copper alloy consisting of 2.41wt% Fe, 0.24wt% Zn, 0.03wt% P, and a balance of Cu was made by the steps of hot working and solution treatment by using an ingot from molten metal of above composition, first cold rolling, seasoning, final cold rolling (working rate 50%) in a condition of a diameter of a final pass roll to be over 100mm, rolling speed of over 200mm/min, and viscosity of rolling oil to be over 0.05cm²/S, and annealing.

However, if the content of Fe exceeds 2.4 wt%, problems take place in that not only material properties, such as conductivity and so on, but also productivity, such as castabilty, become poor significantly. Actually, the Cu-Fe-P group copper alloy in the Example 1 of the above patent document fails to secure high conductivity with 63%IACS, though the copper alloy has comparatively high tensile strength of 530Mpa.

Japanese Laid Open Patent No. 2000-178670 discloses an copper alloy consisting of a sum of 0.05 - 2.0 wt% of Fe or Ni and P, over 5wt% Zn, 0.1 - 3.30wt% Sn, and a balance of Cu, with a ratio of atomic weight of Fe or Ni to P (Fe/P, Ni/P, (Fe+Ni)/P being 0.2 ∼ 0.3, and a grain size controlled to be below 35µm, and an Fe-P compound with a size of below 0.2µm scattered uniformly.

However, even though fine deposit grains are increased owing to a large content of Zn and Sn, there has been a problem in realizing inevitably coexistent Cu-Fe-P group copper alloy.

Japanese Laid Open Patent No. S63-161134 discloses a copper alloy consisting of 0.01 ∼ 0.3wt% Fe, below 0.4wt% P, 1.5 ∼ 5.0wt% Zn, 0.2 ∼ 1.5wt% Sn, and a balance of Cu. Recently, as electronic components become smaller, materials of the electronic components are in a trend of becoming thinner, to require high strength.

However, if it is intended to obtain a high strength copper alloy from above patents, it is required to make a working rate of the cold rolling higher, causing a problem of poor workability.

### [DISCLOSURE OF INVENTION]

### [TECHNICAL PROBLEM]

To solve the problems, an object of the present invention is to provide a copper alloy which has both tensile strength and electrical conductivity superior to those of known products by suitably mixing copper alloy composition, and is thus appropriate for electric and electronic parts, such as a terminal, a connector, a switch, a relay, and the like.

### [TECHNIC SOLUTION]

To achieve these objects and other advantages and in accordance with the purpose of the invention, as embodied and broadly described herein, a high conductibility and high strength copper alloy for electric and electronic components consists of, in 100wt% composition, 0.05 0.25wt% Fe, 0.025 ∼ 0.15wt% P, 0.01 ∼ 0.25wt% Cr, 0.01 ∼ 0.15wt% Si, 0.01 ∼ 0.24wt% Mg, and a balance of Cu and inevitable impurities.

And, the composition may include less than 1.0wt% of at least one of Zn, Sn, Mn, Al, and Ni.

The copper alloy of the present invention having above composition forms Fe-P group deposits in a Cu matrix by Fe grain distribution and coupling of the Fe and P, wherein, if the Fe is below 0.05%, it is difficult to secure strength due to shortage of distribution effect and deposit formation, and if the Fe exceeds 0.25wt%, it is difficult to secure 70%IACS which is a level of a lead frame requirement due to exceeding a proper amount of deposits caused by excessive content of additive elements, which leads to poor electric conductivity.

The copper alloy of the present invention improves electric conductivity and strength by forming Cr-Si group deposits by coupling of the Cr and Si in a Cu matrix, wherein, if a content of the Cr is below 0.01wt%, it is difficult to secure the strength and improve workability due to shortage of formation of the deposits, and if the content of the Cr exceeds 0.25wt%, poor conductivity is resulted in due to coarse Cr-Si group deposits.

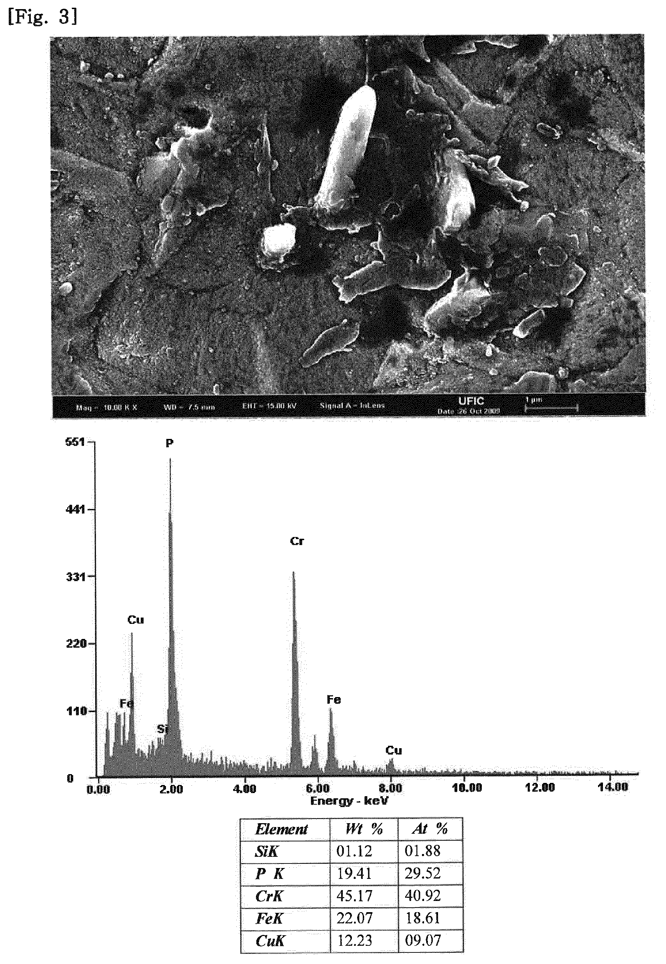

FIG. 3 illustrates a photograph of a scanning electron microscope showing Cr-Si group deposits in a copper matrix.

The copper alloy of the present invention improves electric conductivity and strength by forming Mg-P group deposits by coupling of the Mg and P in a Cu matrix, wherein, if a content of the Mg is below 0.01wt%, it is difficult to secure the strength due to shortage of formation of the deposits, and if the content of the Mg exceeds 0.25wt%, significant drop of the electric conductivity or poor bending workability is resulted in and production cost increases.

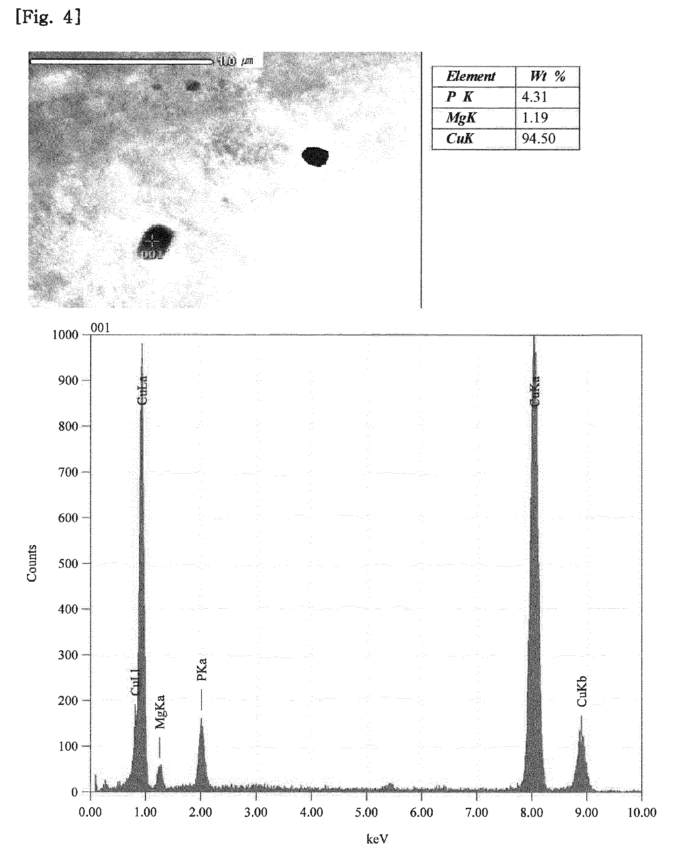

FIG. 4 illustrates a photograph of a scanning electron microscope showing Mg-P group deposit in a copper matrix.

If the content of the Si is below 0.01wt%, the copper alloy of the present invention fails to contribute to the strength due to inadequate formation of the deposits in steps after the steps of melting, casting, and heating ingot, and if the content of the Si exceeds 0.15wt%, the copper alloy of the present invention shows improvement on above effect no more, as well as significant drop of the conductivity.

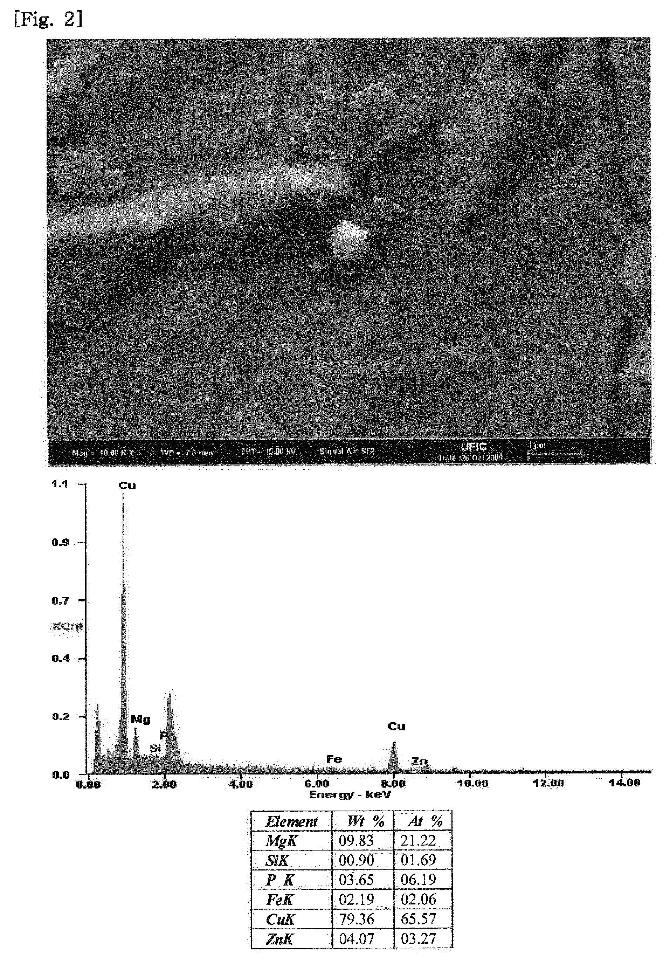

FIG. 2 illustrates a photograph of a scanning electron microscope showing Mg-Si group deposit in a copper matrix.

P is a major element has an oxidizing action, forms deposits with Fe and Mg, and improves strength or heat resistance of the copper alloy, wherein, if the content of the P is below 0.025wt%, no adequate strength or heat resistance are obtained due to inadequate formation of the deposits, and if the content of the P exceeds 0.15wt%, not only the conductivity, but also the heat resistance, hot workability, and press workability become poor.

The Fe, Mg, and P have a ratio of (Mg+Fe)/P = 0.4 50, and preferably, the Fe, Mg, and P have a ratio of (Mg+Fe)/P = 2 ∼ 10.

The Cr, Mg, and Si have a ratio of (Cr+Mg)/Si = 0.1 ∼ 50, and preferably, the Cr, Mg, and Si have a ratio of (Cr+Mg)/Si = 1 - 10.

The composition may include less than 1.0wt% of at least one kind of Zn, Sn, Mn, Al, and Ni, wherein the element affects the electric conductivity and the strength, and if added over 1.0wt%, though the strength increases, the electric conductivity drops.

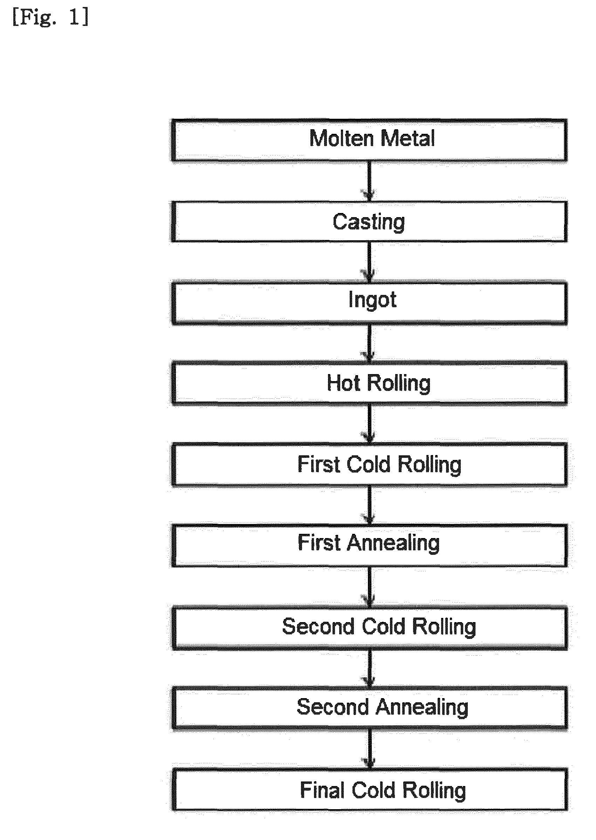

And, referring to FIG. 1, the present invention provides a method for preparing a high strength and high conductivity copper alloy, including the steps of obtaining molten metal of the composition, casting the molten metal to obtain an ingot, and subjecting the ingot to hot rolling at 850 ∼ 1,000°C, cold rolling after cooling, annealing (First annealing) at 400 - 600°C for 1 ∼ 10 hours, intermediate rolling (Second cold rolling) with a reduction ratio of 30 ∼ 70%, heat treating (Second annealing) at 500 ∼ 800°C for 30 ∼ 600 seconds, and finish rolling (Final cold rolling) down to 20 - 40%.

If 1000°C is exceeded in the hot rolling, the formation of the deposits becomes poor on the contrary, and the same takes place at a temperature below 800°C.

And, though there is no particular rule on an upper limit of the reduction ratio at the time of the cold rolling, in general, a good result is obtained at a working rate in a range of below 85%. A high working rate increases a load on a rolling mill.

A proper condition at the first annealing is 400 - 600°C for 1 ∼ 10 hours, wherein, if the 600°C is exceeded, and the 10 hours is exceeded, the temperature and annealing time period affects the strength directly, and the high temperature and long annealing time period shows reduction of the electric conductivity on the contrary, and if the temperature is below the 400°C, and the annealing time period is below one hour, securing the deposits or recrystallization is inadequate.

In the second cold rolling, if a cold working rate is higher than 70%, an amount of distorted material increases, and bending workability becomes poor. Opposite to this, if the cold working rate is below 20%, no adequate strength improvement effect is obtainable.

The second annealing is a distortion removal annealing, wherein, if the annealing is performed at a temperature below 500°C and in a time period below 30 seconds, distortion caused by pressing can not be removed adequately, and if the annealing is performed at a temperature over 750°C and in a time period over 600 seconds, softening of the material progresses, failing to obtain a desired material properties.

### [ADVANTAGEOUS EFFECTS]

Thus, by adding Mg, Cr, and Si to a Cu-Fe-P group alloy, a copper alloy having high conductibility while having high strength and high workability superior to those of known products is obtained without making the conductivity which is a final alloy characteristic poor substantially and without surface defects for enabling to use as semiconductor lead frame material and a transistor material, and to utilize as a connector terminal element with high strength, high conductibility and high workability material.

### [BRIEF DESCRIPTION OF THE DRAWINGS]

FIG. 1 illustrates a flow chart showing the steps of a method for preparing a copper alloy in accordance with a preferred embodiment of the present invention.
FIG. 2 illustrates a photograph of a scanning electron microscope showing Mg-Si group deposit in a copper matrix.
FIG. 3 illustrates a photograph of a scanning electron microscope showing Cr-Si group deposit in a copper matrix.
FIG. 4 illustrates a photograph of a scanning electron microscope showing Mg-P group deposit in a copper matrix.

### [BEST MODE FOR CARRYING OUT THE INVENTION]

Reference will now be made in detail to the specific embodiments of the present invention, examples of which are illustrated in the accompanying drawings.

An alloy on table 1 is melted in a high frequency melting furnace to form an ingot, with a thickness of 22mm, a width of 40mm, and a length of 180mm. The ingot is subjected to heating at a temperature of 950°C for one hour, hot rolling down to a thickness of 10mm, 1 mm surface machining at each side, and cold rolling down to 1.5mm. The cold rolled material is subjected to heat treatment at a temperature of 480°C for three hours, cold rolling down to 0.4mm, distortion removal annealing at a temperature of 650°C, and finish rolling down to 0.25mm, to obtain a cold rolled material shown on table 2.

Moreover, for surface washing, the cold rolled material is subjected to selective seasoning, acid cleaning and polishing, a second heat treatment, and correction processing with a tension leveler.

The method in accordance with the preferred embodiment of the present invention is not limited to this, but may combine steps according to requirements from clients selected from the steps of hot rolling, cold rolling, seasoning, surface cleaning (acid cleaning and polishing), tension annealing, tension leveling, and so on the same as normal practice made in a copper stretching shop for meeting different quality requirements from clients.

**[Table ]**

| 4* | 3 * | Cu | Fe | P | Cr | Si | Mg | Zn | Sn | Mn | Al | Ni |
|---|---|---|---|---|---|---|---|---|---|---|---|---|
| 1* | 1 | bal | 0.22 | 0.05 | 0.02 | 0.03 | 0.02 | | | | | |
| | 2 | bal | 0.07 | 0.03 | 0.15 | 0.04 | 0.08 | | | | | |
| | 3 | bal | 0.11 | 0.04 | 0.03 | 0.02 | 0.15 | | | | | |
| | 4 | bal | 0.14 | 0.07 | 0.09 | 0.03 | 0.2 | | | | | |
| | 5 | bal | 0.22 | 0.05 | 0.22 | 0.03 | 0.02 | 0.003 | 0.002 | | | |
| | 6 | bal | 0.07 | 0.03 | 0.15 | 0.04 | 0.08 | 0.007 | | | | 0.001 |
| | 7 | bal | 0.11 | 0.04 | 0.03 | 0.02 | 0.15 | | 0.006 | | 0.001 | |
| | 8 | bal | 0.14 | 0.07 | 0.09 | 0.03 | 0.2 | 0.001 | | | | 0.005 |
| | 9 | bal | 0.25 | 0.15 | 0.05 | 0.01 | 0.02 | | 0.003 | 0.004 | | |
| | 10 | bal | 0.17 | 0.04 | 0.03 | 0.13 | 0.01 | 0.003 | | | 0.001 | 0.003 |
| 2* | 1 | bal | 0.035 | 0.2 | | | | | | | | |
| | 2 | bal | 0.4 | 0.01 | | | | | | | | |
| | 3 | bal | 0.05 | 0.03 | 0.005 | | | | | | | |
| | 4 | bal | 0.05 | 0.03 | 0.4 | | | | | | | |
| | 5 | bal | 0.07 | 0.04 | 0.01 | 0.01 | 0.005 | | | | | |
| | 6 | bal | 0.08 | 0.2 | 0.03 | 0.02 | 0.4 | | | | | |
| | 7 | bal | 0.05 | 0.04 | 0.03 | 0.004 | 0.03 | | | | | |
| | 8 | bal | 0.1 | 0.04 | 0.02 | 0.3 | 0.03 | | | | | |
| | 9 | bal | 0.07 | 0.03 | 0.15 | 0.04 | 0.08 | 0.5 | 0.6 | | | |
| | 10 | bal | 0.05 | 0.02 | 0.01 | 0.01 | 0.02 | 0.2 | | | | |
| | 11 | bal | 0.14 | 0.07 | 0.09 | 0.03 | 0.2 | | 1.3 | | | |
| | 12 | bal | 0.08 | 0.15 | 0.01 | 0.01 | 0.03 | | | 1.2 | | |
| | 13 | bal | 0.2 | 0.13 | 0.01 | 0.02 | 0.03 | | | | 0.5 | 0.7 |
| C19210 | | bal | 0.12 | 0.035 | | | | | | | | |
| CDA194 | | bal | 2.3 | | | | | | | | | |

| | | | | | | | | | | | | |
|---|---|---|---|---|---|---|---|---|---|---|---|---|
| 1*: Examples of the present invention 2*: Comparative examples 3*: Specimen 4*: Division | | | | | | | | | | | | |

Each of test pieces obtained from the composition and through the preparation process is cut and subjected to tensile strength (TS) test and electric conductivity (EC) test to obtain a test result as shown in table 2.

Tensile strength is measured in accordance with KS B0802, and electric conductivity is measured in accordance with KS D0240.

Surface defects are evaluated by cutting the test piece with a width of 30 and a length of 10mm from a central portion both in a width direction and a length direction of a rolled stripe, and counting defects at both sides thereof with a size longer than 1mm with naked eyes. However, roll marks, dents, scratches, and so on which are basically not related to wholesomeness of the alloy itself are excluded from the counting.

**[Table2]**

| | Alloy No. | TS (N/mm²) | ES (%IACS) |
|---|---|---|---|
| **1*** | 1 | 53 | 74 |
| | 2 | 55 | 70 |
| | 3 | 52 | 75 |
| | 4 | 55 | 69 |
| | 5 | 55 | 73 |
| | 6 | 53 | 71 |
| | 7 | 54 | 75 |
| | 8 | 53 | 74 |
| | 9 | 53 | 75 |
| | 10 | 55 | 72 |
| **2*** | 1 | 43 | 72 |
| | 2 | 50 | 67 |
| | 3 | 51 | 66 |
| | 4 | 50 | 68 |
| | 5 | 50 | 66 |
| | 6 | 52 | 65 |
| | 7 | 51 | 65 |
| | 8 | 53 | 64 |
| | 9 | 53 | 60 |
| | 10 | 48 | 55 |
| | 11 | 51 | 56 |
| | 12 | 53 | 54 |
| | 13 | 54 | 53 |
| C19210 | | 38 | 85 |
| CDA194 | | 40 | 65 |

| | | | |
|---|---|---|---|
| 1*: Examples of the present invention 2*: Comparative examples | | | |

### [MODES FOR CARRYING OUT THE INVENTION]

As can be known from table 1 and table 2, it is evaluated that the specimens 1 to 10 of the present invention are excellent alloys showing good harmony of strength and electric conductivity in comparison to comparative examples 1 ∼ 13 and the related art C19210 and CDA194.

Upon reviewing the properties, though each of specimens 1 to 10 according to the present invention has electric conductivity more or less poorer than the related art C19210 (85%IACS), since each of the specimens 1 to 10 of the present invention has tensile strength of over 52N/mm² which is very excellent in comparison to 38N/mm² of the C19210, the specimens 1 to 10 of the present invention are evaluated as alloys showing good harmony of the strength and the electric conductivity.

It is evaluated that the specimens 1 to 10 of the present invention are alloys each with excellent strength and electric conductivity with good harmony of the strength and the electric conductivity compared to CDA194.

### [Industrial Applicability]

The present invention can be utilized widely as a copper alloy material for semiconductor lead frame material, LED lead frame material, connector terminal and so on having high conductibility and high workability while increasing or maintaining tensile strength.

## Claims

1. A high strength and high conductibility copper alloy consisting of, in 100wt% composition, 0.05 ∼ 0.25wt% Fe, 0.025 ∼ 0.15wt% P, 0.01 ∼ 0.25wt% Cr, 0.01 ∼ 0.15wt% Si, 0.01 ∼ 0.24wt% Mg, and a balance of Cu and inevitable impurities.

2. The copper alloy as claimed in claim 1, wherein the composition includes less than 1.0wt% of at least one selected from the group consisting of Zn, Sn, Mn, Al, and Ni.

3. The copper alloy as claimed in claim 1, wherein the Fe, Mg, and P have a ratio of (Mg+Fe)/P = 0.4 ∼ 50.

4. The copper alloy as claimed in claim 3, wherein the Fe, Mg, and P have a ratio of (Mg+Fe)/P = 2 ∼ 10.

5. The copper alloy as claimed in claim 1, wherein the Cr, Mg, and Si have a ratio of (Cr+Mg)/Si = 0.1 - 50.

6. The copper alloy as claimed in claim 5, wherein the Cr, Mg, and Si have a ratio of (Cr+Mg)/Si = 1 ∼ 10.

7. A method for preparing a high strength and high conductibility copper alloy, comprising the steps of:
obtaining molten metal of a high strength and high conductivity copper alloy consisting of, in 100wt% composition, 0.05 - 0.25wt% Fe, 0.025 ∼ 0.15wt% P, 0.01 ∼ 0.25wt% Cr, 0.01 - 0.15wt% Si, 0.01 ∼ 0.24wt% Mg, and a balance of Cu and inevitable impurities;
casting the molten metal to obtain an ingot; and
subjecting the ingot to hot rolling at 850 - 1,000°C, cold rolling after cooling, annealing at 400 - 600°C for 1 10 hours, intermediate rolling with a reduction ratio of 30 ∼ 70%, heat treating at 500 - 800°C for 30 ∼ 600 seconds, and finish rolling with a reduction ratio of 20 ∼ 40%.

8. The method as claimed in claim 7, wherein the composition includes less than 1.0wt% of at least one selected from the group consisting of Zn, Sn, Mn, Al, and Ni.

9. The method as claimed in claim 7 or 8, wherein the step of seasoning includes the step of making the copper alloy to secure high strength by forming an Fe-P group, an Mg-P group, and a Cr-Si group, a Mg-Si group deposits.
